(19) Europäisches Patentamt / European Patent Office / Office européen des brevets

(11) EP 3 276 986 B1

(12) FASCICULE DE BREVET EUROPEEN

(45) Date de publication et mention de la délivrance du brevet:
07.10.2020 Bulletin 2020/41

(51) Int Cl.:
H03L 7/08 *(2006.01)*  H04W 4/00 *(2018.01)*
H03L 7/099 *(2006.01)*  H03L 7/14 *(2006.01)*
H03L 7/23 *(2006.01)*  H04B 5/00 *(2006.01)*
H04W 4/80 *(2018.01)*

(21) Numéro de dépôt: 17156586.4

(22) Date de dépôt: 17.02.2017

(54) **PROCÉDÉ DE COMMUNICATION SANS CONTACT ENTRE UN OBJET, PAR EXEMPLE UN TÉLÉPHONE MOBILE ÉMULÉ EN MODE CARTE, ET UN LECTEUR PAR MODULATION ACTIVE DE CHARGE**

KONTAKTLOSES KOMMUNIKATIONSVERFAHREN ZWISCHEN EINEM OBJEKT, BEISPIELSWEISE EINEM IM KARTENMODUS EMULIERTEN MOBILTELEFON, UND EINEM LESEGERÄT DURCH AKTIVE LASTMODULATION

METHOD OF CONTACTLESS COMMUNICATION BETWEEN AN OBJET, FOR EXAMPLE A CARD EMULATED MOBILE PHONE, AND A READER BY ACTIVE LOAD MODULATION

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: 27.07.2016 FR 1657226

(43) Date de publication de la demande:
31.01.2018 Bulletin 2018/05

(73) Titulaire: STMICROELECTRONICS SA
92120 Montrouge (FR)

(72) Inventeurs:
• DEDIEU, Sébastien
38660 La Terrasse (FR)
• HOUDEBINE, Marc
38920 Crolles (FR)

(74) Mandataire: Casalonga
Casalonga & Partners
Bayerstraße 71/73
80335 München (DE)

(56) Documents cités:
EP-A1- 2 431 926    EP-A1- 2 843 840
EP-A2- 2 680 457    US-A1- 2016 142 113

• MICHAEL GEBHART ET AL: "Active load modulation for contactless near-field communication", RFID-TECHNOLOGIES AND APPLICATIONS (RFID-TA), 2012 IEEE INTERNATIONAL CONFERENCE ON, IEEE, 5 novembre 2012 (2012-11-05), pages 228-233, XP032299612, DOI: 10.1109/RFID-TA.2012.6404518 ISBN: 978-1-4673-4656-6

**Description**

Des modes de mise en œuvre et de réalisation de l'invention concernent la communication sans fil entre un lecteur et un objet, par exemple mais non limitativement un téléphone mobile émulé en mode carte, en particulier un objet NFC (« Near Field Communication »), et plus particulièrement la compensation d'un déphasage entre le signal émis par l'objet et celui reçu du lecteur lors d'une communication par modulation active de charge (ALM : Active Load Modulation).

La communication champ proche, plus connue par l'homme du métier sous la dénomination anglosaxonne NFC (« Near Field Communication ») est une technologie de connectivité sans fil qui permet une communication sur une courte distance, par exemple 10 cm, entre des dispositifs électroniques, comme par exemple des cartes à puce sans contact ou des téléphones mobiles émulés en mode carte, et des lecteurs.

La technologie NFC est particulièrement adaptée pour connecter tout type de dispositif utilisateur et permet des communications rapides et faciles.

Un objet sans contact est un objet capable d'échanger des informations via une antenne avec un autre objet sans contact, par exemple un lecteur, selon un protocole de communication sans contact.

Un objet NFC, qui est un objet sans contact, est un objet compatible avec la technologie NFC.

La technologie NFC est une plate-forme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC. EP2843840 illustre la synchronisation de l'horloge entre deux dispositifs qui échangent des données en utilisant le moyen de communication en champ proche (NFC) et en appliquant des techniques de modulation de charge active (ALM).

Outre sa fonction classique de téléphone, un téléphone mobile cellulaire peut être utilisé (s'il est équipé de moyens spécifiques) pour échanger des informations avec un autre dispositif sans contact, par exemple un lecteur sans contact, en utilisant un protocole de communication sans contact utilisable dans la technologie NFC.

Ceci permet d'échanger des informations entre le lecteur sans contact et des éléments sécurisés situés dans le téléphone mobile. De nombreuses applications sont ainsi possibles comme la billetterie mobile dans les transports publics (le téléphone mobile se comporte comme un ticket de transport) ou bien le paiement mobile (le téléphone mobile se comporte comme une carte de paiement).

Lors d'une transmission d'information entre un lecteur et un objet émulé en mode étiquette ou carte, le lecteur génère un champ magnétique par l'intermédiaire de son antenne qui est généralement dans les normes classiquement utilisées, une onde sinusoïdale à 13,56MHz. La force du champ magnétique est comprise entre 0,5 et 7,5 ampères/mètre RMS (« Root Mean Square » en anglais).

Deux modes de fonctionnement sont alors possibles, un mode passif ou un mode actif.

Dans le mode passif, seul le lecteur génère le champ magnétique et l'objet, émulé en mode étiquette ou carte, est alors passif et joue toujours le rôle de la cible.

Plus précisément, l'antenne de l'objet émulant l'étiquette ou la carte module le champ généré par le lecteur.

Cette modulation est effectuée en modifiant la charge connectée aux bornes de l'antenne de l'objet.

En modifiant la charge aux bornes de l'antenne de l'objet, l'impédance de sortie de l'antenne du lecteur change en raison du couplage magnétique entre les deux antennes. Il en résulte un changement dans les amplitudes et/ou les phases des tensions et courants présents au niveau des antennes du lecteur et de l'objet.

Et, de cette façon, les informations à transmettre depuis l'objet vers le lecteur sont transmises par modulation de charge aux courants d'antenne du lecteur.

La variation de charge effectuée lors de la modulation de charge se traduit par une modulation d'amplitude et/ou de phase du signal (tension ou courant) au niveau de l'antenne du lecteur. Une copie du courant d'antenne est générée et injectée dans la chaîne de réception du lecteur où ce courant est démodulé et traité de façon à extraire les informations transmises.

Dans le mode de fonctionnement actif, le lecteur et l'objet émulé en mode carte génèrent tous les deux un champ électromagnétique. Généralement, ce mode de fonctionnement est utilisé lorsque l'objet est pourvu d'une source d'alimentation propre, par exemple une batterie, comme c'est le cas dans un téléphone mobile cellulaire qui est alors émulé en mode carte.

Chacun des dispositifs NFC transmet les données en utilisant un schéma de modulation, typiquement un schéma de modulation en amplitude du type ASK (« Amplitude Shift Keying »).

Là encore, la modulation se traduit par une modification de charge et l'on parle alors d'une communication par modulation active de charge.

Par rapport à un mode de communication passif, on obtient des distances de fonctionnement plus importantes qui peuvent aller jusqu'à 20 cm en fonction du protocole utilisé.

Par ailleurs, l'utilisation d'une modulation active de charge permet d'utiliser des antennes très petites.

Cela étant, ce type de communication par modulation active de charge pose d'autres problèmes.

En effet, durant les périodes de communication active du dispositif émulé en mode carte, le champ électromagnétique du lecteur n'est pas directement observable. Et ceci peut conduire à une réponse de l'objet émulé en mode carte non synchrone et par conséquent à un signal reçu par le lecteur présentant un décalage de phase, en particulier lors de longues périodes d'émission par le dispositif émulé en mode carte.

Aussi, si l'on considère deux dispositifs indépendants, à savoir le lecteur et un objet émulé en mode carte, capables de communiquer sans contact par une modulation active de charge, il existe par conséquent un besoin pour réduire au maximum voire supprimer ce décalage de phase.

Selon un aspect, il est proposé un procédé de communication sans contact d'un objet avec un lecteur par modulation active de charge.

Le procédé selon cet aspect comprend un premier mode de communication comportant une génération d'un signal d'horloge principal au sein dudit objet incluant une phase d'étalonnage et une phase d'émission.

La phase d'étalonnage comporte un asservissement du signal de sortie d'un oscillateur principal commandé (cet oscillateur principal peut être commandé en tension ou bien commandé numériquement) sur la phase et la fréquence d'un signal d'horloge secondaire reçu du lecteur, et une estimation d'un rapport de fréquences entre la fréquence de sortie de l'oscillateur principal et une fréquence de référence d'un signal de référence issu d'un oscillateur de référence.

Cet oscillateur de référence, distinct de l'oscillateur principal commandé, délivre un signal de référence dont la fréquence de référence peut être identique ou différente de celle du signal de sortie de l'oscillateur principal.

Par ailleurs, la phase d'émission comporte un asservissement uniquement en fréquence du signal de sortie de l'oscillateur principal sur la fréquence du signal de référence corrigé par ledit rapport estimé.

Le signal d'horloge principal est alors issu du signal de sortie de l'oscillateur principal, par exemple mais non nécessairement, par une division de fréquence.

Ainsi, pendant la phase d'étalonnage, l'oscillateur principal se cale en phase et en fréquence sur le signal reçu du lecteur. Puis, lors d'une phase d'émission d'informations de l'objet vers le lecteur, le signal d'horloge délivré par l'objet, et qui va permettre, par une modulation d'amplitude ou de phase, de transmettre les données vers le lecteur, est asservi en fréquence sur la fréquence de l'oscillateur de référence par le rapport de fréquences estimé (ce qui se traduit donc *in fine* par un signal d'horloge principal ayant la fréquence désirée, par exemple 13,56 MHz) et cet asservissement uniquement en fréquence ne modifie pas la phase du signal d'horloge principal qui avait été réglée au préalable sur celle du signal reçu par le lecteur dans la phase d'étalonnage.

Le déphasage éventuel entre le signal d'horloge reçu du lecteur et le signal d'horloge émis par l'objet est par conséquent réduit au maximum voire supprimé.

Plusieurs possibilités existent pour estimer le rapport de fréquences entre la fréquence du signal de sortie de l'oscillateur principal et la fréquence de référence du signal de référence issu de l'oscillateur de référence.

On peut par exemple effectuer des mesures glissantes entre la fréquence du signal de sortie de l'oscillateur principal et la fréquence de référence. On peut par exemple utiliser à cet égard le procédé décrit dans la demande de brevet français déposée sous le n°15 61153 et correspondant à la demande de brevet Etats Unis déposée sous le n° 15 139801.

En variante, l'asservissement du signal de sortie de l'oscillateur principal pendant la phase d'étalonnage peut être effectué au sein d'une boucle à verrouillage de phase et l'estimation du rapport de fréquences peut être alors effectuée au sein d'une boucle à verrouillage de fréquence à partir d'un filtre adaptatif connecté à la sortie du filtre de boucle de la boucle à verrouillage de phase et rebouclé sur le filtre de boucle de la boucle à verrouillage de fréquence, le mot de sortie du filtre adaptatif formant un mot de consigne pour la boucle à verrouillage de fréquence, les deux filtres de boucle ayant une même fréquence de coupure.

Ainsi, selon un mode de mise en œuvre, pendant la phase d'émission, on peut déconnecter de l'oscillateur principal, le filtre de boucle de la boucle à verrouillage de phase, on fige la sortie du filtre adaptatif et on asservit uniquement en fréquence le signal de sortie de l'oscillateur principal sur la fréquence du signal de référence corrigé par le mot de sortie du filtre adaptatif, qui est représentatif dudit rapport de fréquences.

Selon encore une autre variante possible, l'asservissement du signal de sortie de l'oscillateur principal pendant la phase d'étalonnage peut être effectué au sein d'une boucle à verrouillage de phase et l'estimation du rapport de fréquence peut être effectué par un système comportant la boucle à verrouillage de phase et une boucle à verrouillage de fréquence à partir d'un filtre intégrateur stabilisateur dont la sortie forme un mot de consigne pour la boucle à verrouillage de fréquence, le filtre intégrateur stabilisateur étant connecté à l'entrée du filtre de boucle de la boucle à verrouillage de fréquence ; le filtre de boucle de la boucle à verrouillage de phase comporte ledit filtre intégrateur stabilisateur ainsi que le filtre de boucle de la boucle à verrouillage de fréquence.

Ainsi, selon un mode de mise en œuvre, pendant la phase d'émission on ouvre la boucle à verrouillage de phase, on fige la sortie du filtre intégrateur stabilisateur et on asservit uniquement en fréquence le signal de sortie de l'oscillateur principal sur la fréquence du signal de référence corrigé par le mot de sortie du filtre intégrateur stabilisateur, qui est là encore représentatif dudit rapport de fréquences.

Il est également possible que le procédé comprenne un deuxième mode de communication comportant une génération du signal d'horloge principal au sein dudit objet incluant uniquement un asservissement du signal de sortie de l'oscillateur principal commandé sur la phase et la fréquence du signal d'horloge secondaire reçu du lecteur.

Ce deuxième mode de communication correspond par exemple à une alternance de fermetures de la boucle à verrouillage de phase sur le signal reçu du lecteur et de mises en roue libre de l'oscillateur principal commandé (ouvertures de ladite boucle) pendant l'émission du champ par l'objet.

Alors que le premier mode de communication mentionné ci-avant est particulièrement avantageux lorsque les périodes d'émission par l'objet émulé en mode carte sont longues, car il permet, comme expliqué ci-avant, de réduire au maximum voire supprimer le décalage de phase, le deuxième mode de communication peut par exemple être utilisé lors de périodes d'émission plus courtes car de telles périodes courtes ne conduisent pas à un décalage de phase significatif.

Le procédé peut comprendre en outre une génération du signal d'horloge principal modulé en phase par une modulation par changement de phase (PSK : Phase Shift Keying).

Selon un autre aspect, il est proposé un objet capable de communiquer sans contact avec un lecteur par modulation active de charge, comprenant des moyens de traitement comportant
des moyens de génération configurés pour générer un signal d'horloge principal à partir du signal de sortie d'un oscillateur principal commandé ; les moyens de génération comportant des premiers moyens d'asservissement configurés pour effectuer un asservissement du signal de sortie de l'oscillateur principal sur la phase et la fréquence d'un signal d'horloge secondaire reçu du lecteur, des moyens d'estimation configurés pour effectuer une estimation d'un rapport de fréquences entre la fréquence du signal de sortie de l'oscillateur principal et une fréquence de référence d'un signal de référence issu d'un oscillateur de référence, des deuxièmes moyens d'asservissement configurés pour effectuer un asservissement uniquement en fréquence du signal de sortie de l'oscillateur principal sur la fréquence du signal de référence corrigée par ledit rapport estimé, et
des moyens de commande configurés pour activer tout d'abord les premiers moyens d'asservissement et les moyens d'estimation puis pour activer les deuxièmes moyens d'asservissement.

Selon une variante,
les premiers moyens d'asservissement comportent une boucle à verrouillage de phase comportant ledit oscillateur principal,
les moyens d'estimation comportent des moyens configurés pour effectuer des mesures glissantes entre la fréquence du signal de sortie de l'oscillateur principal et la fréquence de référence et un moyen de stockage configuré pour stocker le rapport de fréquences estimé, et
les deuxièmes moyens d'asservissement comportent une boucle à verrouillage de fréquence comportant ledit oscillateur principal, une entrée de référence pour recevoir le signal de référence et configurée pour recevoir le contenu dudit moyen de stockage en tant que mot de consigne.

Selon une autre variante,
les premiers moyens d'asservissement comportent une boucle à verrouillage de phase comportant ledit oscillateur principal et un premier filtre de boucle,
les moyens d'estimation comportent une boucle à verrouillage de fréquence possédant une entrée de référence pour recevoir le signal de référence, un deuxième filtre de boucle, un filtre adaptatif connecté à la sortie du premier filtre de boucle et rebouclé sur le deuxième filtre de boucle, le mot de sortie du filtre adaptatif formant un mot de consigne pour la boucle à verrouillage de fréquence,
les deux filtres de boucle ayant une même fréquence de coupure.

Selon un mode de réalisation, les moyens de commande sont configurés pour déconnecter l'oscillateur principal du premier filtre de boucle de façon à désactiver la boucle à verrouillage de phase, figer la sortie du filtre adaptatif et connecter la sortie du filtre adaptatif sur la boucle à verrouillage de fréquence de façon à asservir uniquement en fréquence le signal de sortie de l'oscillateur principal sur la fréquence du signal de référence corrigée par le mot de sortie du filtre adaptatif.

Selon encore une autre variante,
les premiers moyens d'asservissement comportent une boucle à verrouillage de phase comportant ledit oscillateur principal,
les moyens d'estimation comportent une boucle à verrouillage de fréquence possédant une entrée de référence pour recevoir le signal de référence, un filtre de boucle, un filtre intégrateur stabilisateur connecté à l'entrée du filtre de boucle, la sortie du filtre intégrateur stabilisateur formant un mot de consigne pour la boucle à verrouillage de fréquence,
la boucle à verrouillage de phase possédant un filtre de boucle comportant ledit intégrateur et stabilisateur ainsi que le filtre de boucle de la boucle à verrouillage de fréquence.

Selon un mode de réalisation, les moyens de commande sont configurés pour ouvrir la boucle à verrouillage de phase de façon à désactiver la boucle à verrouillage de phase, figer la sortie du filtre intégrateur stabilisateur et connecter la sortie du filtre intégrateur et stabilisateur sur la boucle à verrouillage de fréquence de façon à asservir uniquement en fréquence le signal de sortie de l'oscillateur principal sur la fréquence du signal de référence corrigée par le mot de sortie du filtre intégrateur stabilisateur, qui correspond à la consigne de cette boucle à verrouillage de fréquence.

Selon un mode de réalisation, les moyens de commande sont en outre configurés, par exemple dans un deuxième mode de communication, pour activer uniquement la boucle à verrouillage de phase de façon à permettre une génération du signal d'horloge principal au sein dudit objet incluant uniquement un asservissement du signal de sortie de l'oscillateur principal commandé sur la phase et la fréquence du signal d'horloge secondaire reçu du lecteur.

Selon un mode de réalisation, les moyens de traitement comportent des moyens de modulation d'amplitude configurés pour appliquer une modulation d'amplitude sur le signal d'horloge principal généré.

Selon un mode de réalisation, les moyens de génération comportent des moyens de modulation de phase configurés pour appliquer préalablement à la délivrance du signal d'horloge principal, une modulation de phase du type modulation par changement de phase.

Selon un mode de réalisation, les moyens de modulation de phase sont configurés pour injecter la modulation de phase de part et d'autre du ou des filtres de boucle de la boucle à verrouillage de phase et/ou de la boucle à verrouillage de fréquence.

L'objet peut être par exemple un téléphone mobile cellulaire émulé en mode carte.

D'autres avantages et caractéristiques de l'invention apparaîtront à la lecture de la description détaillée de modes de mise en œuvre et de réalisation, nullement limitatifs, et des dessins annexés sur lesquels :

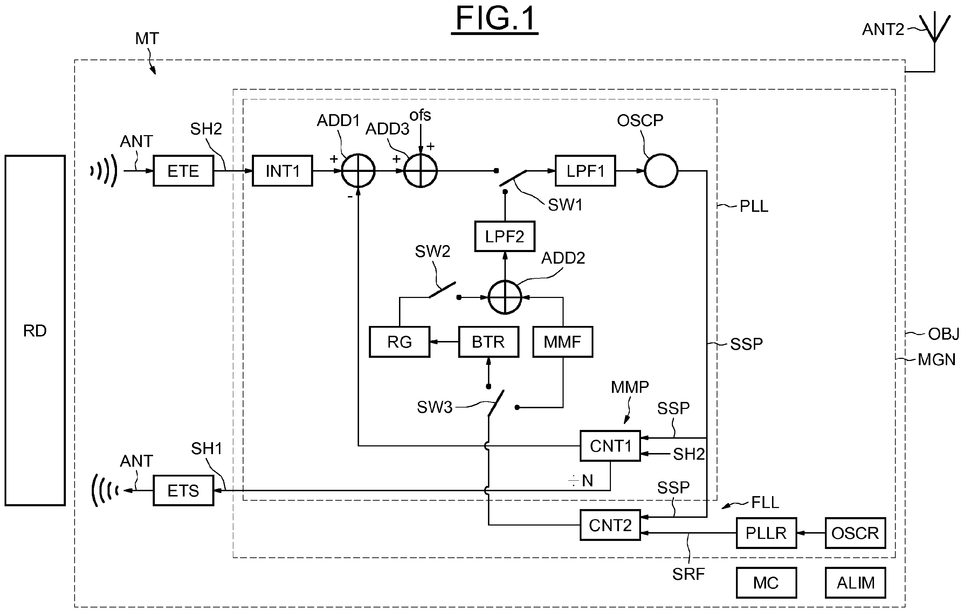

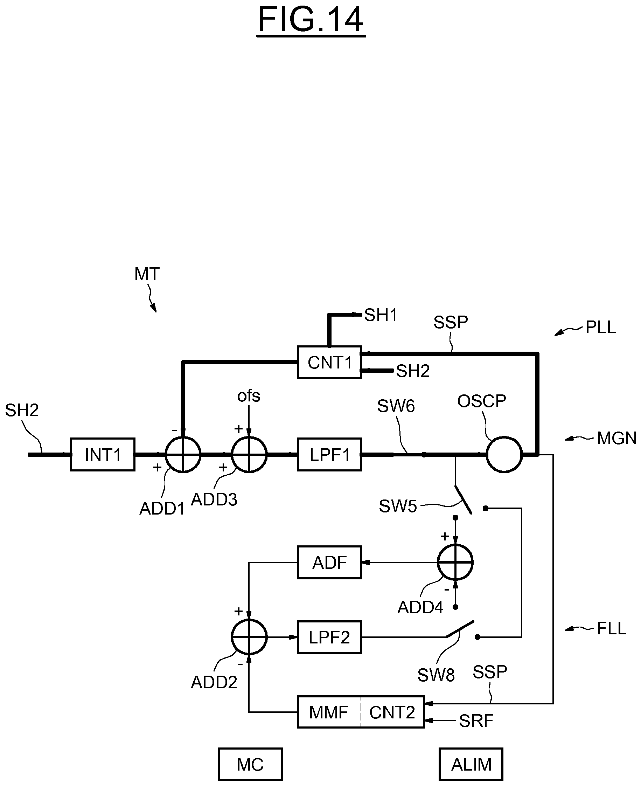

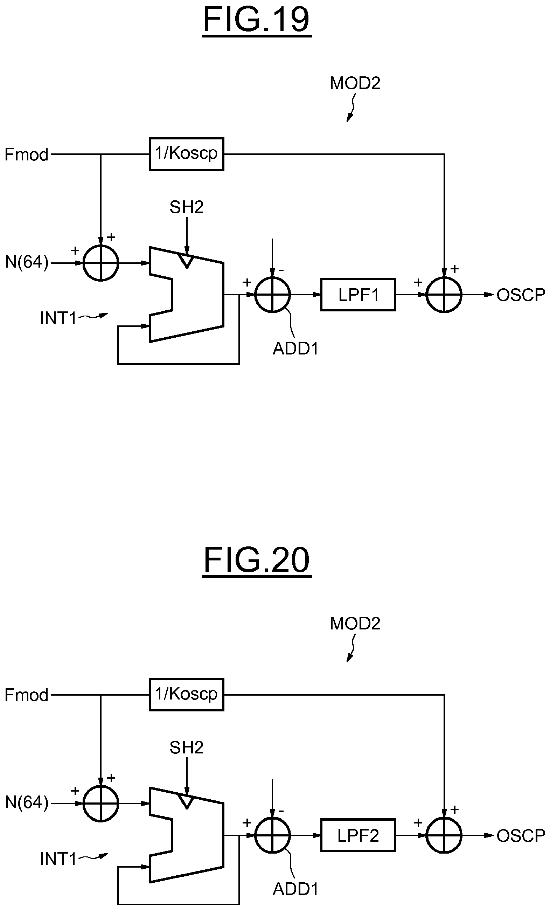

- les figures 1 à 20 illustrent schématiquement différents modes de mise en œuvre et de réalisation de l'invention.

Sur la figure 1, la référence OBJ désigne un objet, par exemple un téléphone mobile cellulaire comportant une antenne ANT2 pour les communications téléphoniques. Par ailleurs, ce téléphone comporte des moyens de traitement MT capables de gérer une communication sans contact via une autre antenne ANT, par exemple une bobine inductive, avec un lecteur RD par une modulation active de charge.

Le téléphone OBJ est par conséquent dans ce cas émulé en mode carte et comporte sa propre alimentation ALIM, par exemple une batterie, lui permettant, dans le cadre de la modulation active de charge, de générer son propre champ électromagnétique à travers l'antenne ANT.

Les moyens de traitement comportent ici outre l'antenne ANT, un étage d'entrée de réception, de structure classique et connue en soi, délivrant un signal d'horloge SH2 reçu du lecteur RD.

Les moyens de traitement comportent par ailleurs un étage de sortie ETS connecté à l'antenne ANT en vue de moduler le champ électromagnétique à partir d'un signal d'horloge SH1 lors d'une phase d'émission.

Dans la suite, le signal SH1 est dénommé « signal d'horloge principal » tandis que le signal SH2 est désigné par « signal d'horloge secondaire ».

Par ailleurs, à des fins de simplification, bien que deux antennes ANT aient été respectivement représentées couplées à l'étage ETE et à l'étage ETS, il s'agit bel et bien de la même antenne ANT.

Les moyens de traitement MT comportent également des moyens de génération MGN configurés pour générer le signal d'horloge principal SH1 à partir du signal de sortie SSP d'un oscillateur principal OSP. Cet oscillateur OSP est ici un oscillateur commandé numériquement mais il pourrait être également un oscillateur commandé en tension.

D'une façon générale, les moyens de génération comportent des premiers moyens d'asservissement configurés pour effectuer un asservissement du signal de sortie SSP de l'oscillateur principal sur la phase et la fréquence du signal d'horloge secondaire SH2 reçu du lecteur.

Les moyens de génération MGN comportent par ailleurs des moyens d'estimation configurés pour effectuer une estimation d'un rapport de fréquence entre la fréquence FRP du signal de sortie SSP de l'oscillateur principal OSCP et une fréquence de référence FRF d'un signal de référence SRF issu d'un oscillateur de référence OSCR. Dans l'exemple décrit ici, une boucle à verrouillage de phase PLLR est associée à l'oscillateur OSCR.

Les moyens de génération MGN comportent également des deuxièmes moyens d'asservissement configurés pour effectuer un asservissement uniquement en fréquence du signal de sortie SSP de l'oscillateur principal sur la fréquence du signal de référence SRF corrigée par le rapport estimé FRP/FRF.

Par ailleurs, des moyens de commande MC sont configurés pour, dans un premier mode de communication, activer tout d'abord les premiers moyens d'asservissement et les moyens d'estimation lors d'une phase d'étalonnage puis pour activer les deuxièmes moyens d'asservissement lors d'une phase d'émission.

Plusieurs modes de réalisation sont possibles pour implémenter ces différents moyens.

La figure 1 illustre l'un de ces modes de réalisation.

Plus précisément, les premiers moyens d'asservissement comportent ici une boucle à verrouillage de phase PLL comportant un intégrateur INT1, un filtre de boucle LPF1, l'oscillateur principal OSCP ainsi que des moyens de mesure de phase MMP comportant ici un compteur CNT1 recevant d'une part le signal SSP de sortie de l'oscillateur principal et le signal d'horloge secondaire SH2 reçu du lecteur.

La sortie du compteur CNT1 est rebouclée en sortie de l'intégrateur INT1 par l'intermédiaire d'un additionneur ADD1.

Dans la suite du texte et par abus de langage habituellement utilisé par l'homme du métier, le terme « additionneur » englobe la fonction « sommation » ou la fonction « soustraction », selon les signes + ou - figurant sur les entrées de l'additionneur.

Par ailleurs, optionnellement, un additionneur ADD3 permet de rajouter un décalage de phase ofs représentatif du décalage de phase occasionné par les moyens disposés entre l'antenne et la boucle à verrouillage de phase.

Les moyens d'estimation comportent quant à eux des moyens configurés pour effectuer des mesures glissantes entre la fréquence FRP du signal de sortie SSP de l'oscillateur principal OSCP et la fréquence de référence FRF de signal de référence SRF, ainsi qu'un moyen de stockage, par exemple un registre RG configuré pour stocker ce rapport de fréquences estimé FRP/FRF.

Les deuxièmes moyens d'asservissement comportent quant à eux une boucle à verrouillage de fréquence FLL comportant également ledit oscillateur principal OSCP, une entrée de référence pour recevoir le signal de référence SRF et configurée pour recevoir le contenu du moyen de stockage RG en tant que mot de consigne.

L'entrée de référence est l'entrée de cadencement d'une bascule d'un compteur CNT2 recevant par ailleurs le signal SSP.

Dans l'exemple décrit ici, compatible avec les protocoles de communication sans contact NFC, la fréquence du signal SH2 est égale à 13,56 MHz et cette fréquence doit aussi être celle du signal d'horloge principal SH1.

Par contre, dans le cas présent, la fréquence du signal de sortie SSP de l'oscillateur principal est choisie égale à N x 13,56 MHz, avec N par exemple égal à 64.

Quant à la fréquence FRF du signal de référence SRF délivré par l'oscillateur de référence OSCR, elle peut être quelconque mais en pratique elle est choisie comprise entre une dizaine de MHz et une centaine de MHz, par exemple 18 MHz, sans que cet exemple ne soit limitatif.

Avec des valeurs de 867,84 MHz (64x13,56 MHz) et de 18 MHz pour respectivement la fréquence FRP du signal SSP et celle FRF du signal SRF, le rapport de fréquence entre la fréquence FRP la fréquence FRF est par conséquent égal à 48,2133.

Dans le cas présent, alors que la sortie du compteur CNT1 délivre la différence de phase entre les signaux SH2 et SSP, l'une des bascules du compteur CNT1 permet de délivrer le signal SH1 dont la fréquence est divisée par N, par exemple 64, par rapport à celle du signal SSP de façon à retrouver la fréquence de 13,56 MHz.

Cela étant pour effectuer cette division par N, on pourrait aussi utiliser un diviseur en parallèle du compteur CNT1.

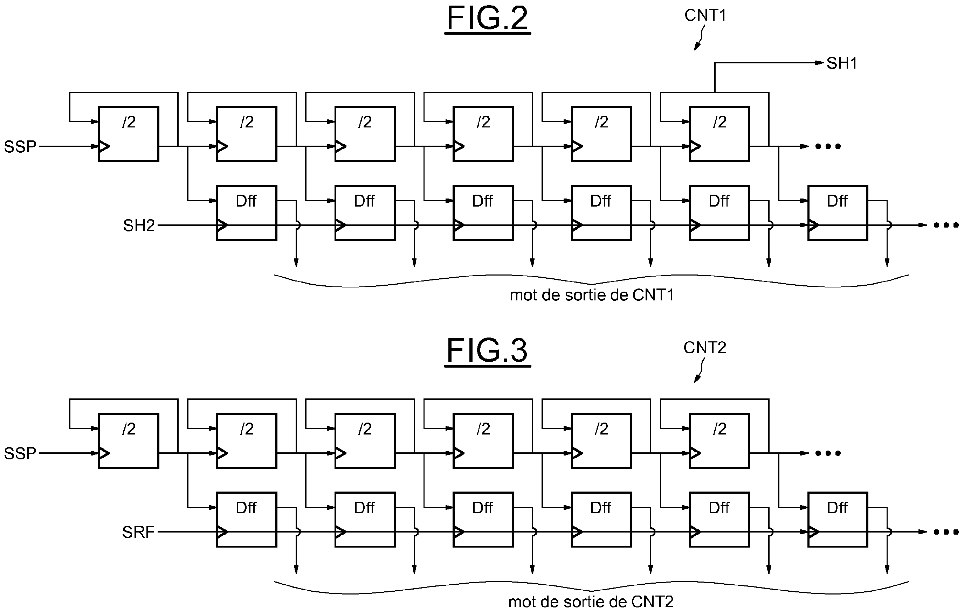

Un exemple non limitatif de réalisation du compteur CNT1 est illustré sur la figure 2.

Le signal SSP issu de l'oscillateur OSCP incrémente le compteur CNT1 comportant par exemple des diviseurs par 2 couplés en série. Le signal SH2 commande des bascules D référencées Dff qui vont saisir le résultat de comptage à chaque front du signal SH2.

La sortie SH1 correspond à la $N^{\text{ième}}$ division de SSP.

Un exemple de réalisation du compteur CNT2 est illustré sur la figure 3.

La structure du compteur CNT2 est identique à celle du compteur CNT1. C'est cette fois ci le signal SRF qui commande les bascules D référencées Dff qui vont saisir le résultat de comptage à chaque front du signal SRF. L'entrée de référence qui reçoit le signal SRF est l'entrée de cadencement de chaque bascule Dff. La sortie du compteur CNT2 permettrait déjà par différences successives des résultats du compteur, d'obtenir le rapport de fréquence mentionné ci-avant.

Cela étant, il est particulièrement avantageux, afin d'estimer plus rapidement ce rapport de fréquence, d'utiliser un bloc de traitement BTR permettant d'effectuer des mesures glissantes entre la fréquence du signal SSP et celle du signal SRF.

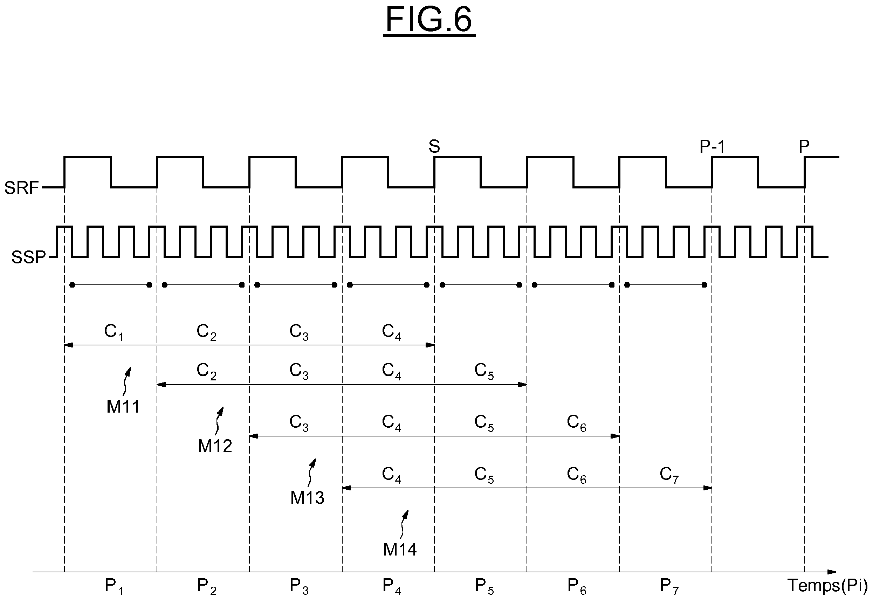

On peut à cet égard utiliser le procédé de détermination de la fréquence du signal SSP à partir du signal de référence SRF décrite dans la demande de brevet français précédemment mentionnée n° 15 61153 et dont on en rappelle ici certaines caractéristiques en se référant plus particulièrement à la figure 6.

La figure 6 illustre un exemple d'un procédé de détermination d'une fréquence du signal SSP, à partir du signal de référence SRF.

Dans la suite de la description de cette figure, l'indice i sera utilisé pour représenter les différents éléments associés à une période $P_i$ du signal de référence. Ainsi, un indice 1 est associé à la période $P_1$, un indice 2 à la période $P_2$, etc.

Lors d'une première étape a) du procédé, on réalise un comptage d'un nombre $C_i$ de périodes entières du signal SSP durant une première période de référence $P_1$ du signal de référence SRF.

On répète (étape b)) le comptage a) pour chaque autre période successive $P_i$ du signal de référence SRF, durant une première quantité S de périodes de référence $P_i$.

Dans cet exemple S=4. On réalise donc les comptages successifs des nombres $C_1$, $C_2$, $C_3$ et $C_4$ de périodes entières du premier signal SIG ayant lieu durant les périodes successives $P_1$, $P_2$, $P_3$ et $P_4$.

On réalise ensuite (étape c)) une première moyenne M11 des différents nombres $C_i$ comptés durant les quatre répétitions de la première étape a). Dans cette exemple, la première moyenne M11 sera égale à la somme des nombre $C_1$, $C_2$, $C_3$, et $C_4$, divisée par la première quantité S=4.

On répète les étapes a) à c), une quantité de fois égale à la différence entre une deuxième quantité P de périodes de référence et la première quantité S=4, en décalant le début du comptage d'une période de référence $P_i$ à chaque répétition.

Dans cet exemple, P=8. On réalise donc parallèlement P-S=4 premières moyennes M11, M12, M13, et M14 portant chacune sur 4 nombres $C_i$ successifs.

M11 est donc la moyenne des nombres $C_1$ à $C_4$, M12 la moyenne des nombre $C_2$ à $C_5$, M13 la moyenne des nombre $C_3$ à $C_6$, et M14 la moyenne des nombre $C_3$ à $C_7$.

Enfin, on réalise une deuxième moyenne M2 sur les valeurs des premières moyennes M11, M12, M13, et M14.

Ici, la valeur de la deuxième moyenne M2 est donc égale à la somme des premières moyennes M11, M12, M13, et M14, divisée par P-S=4.

Afin d'obtenir la fréquence du signal SSP, on multiplie ensuite la fréquence du signal de référence SRF par la valeur de la deuxième moyenne M2.

En d'autres termes la valeur de la deuxième moyenne M2 est le rapport de fréquences FRP/FRF que l'on a cherché à estimer.

Le procédé ainsi effectué est équivalent à l'application de la première formule F1 suivante:

$$M2 = \frac{1}{P-S} * \left( \sum_{k=1}^{P-S} \frac{1}{S} \sum_{i=k}^{k+S-1} C_i \right) \qquad (F1)$$

Cette formule pourrait être mise en œuvre de façon logicielle au sein d'un microcontrôleur par exemple.

Cela étant, les inventeurs ont observé qu'en choisissant la première quantité S et la deuxième quantité P comme étant des puissances de deux et particulièrement en choisissant $S = \frac{P}{2}$, le procédé est équivalent à l'application de la deuxième formule F2 suivante :

$$M2 = \frac{1}{P-S} * \frac{1}{S} * \left( \sum_{i=1}^{S} i * C_i + \sum_{i=S+1}^{P-1} (P-i) * C_i \right) \qquad (F2)$$

Cette formule est particulièrement avantageuse car elle permet non seulement d'appliquer la formule avec des moyens logiciels, mais aussi avec des moyens matériels simples.

Il est alors également possible de ne pas répéter à chaque répétition le comptage de certains nombres $C_i$ et de conserver ces nombres $C_i$ pour ensuite les pondérer.

Si l'on revient maintenant à la figure 1, de façon à placer les moyens de génération MGN soit dans une phase d'étalonnage soit dans une phase d'émission, on a représenté ici une série de commutateurs SW1, SW2 et SW3 commandés par les moyens de commande MC.

Les commutateurs sont ici représentés pour illustrer des commutations fonctionnelles entre les différents éléments. Bien entendu, différentes façons sont possibles pour réaliser ces commutations. On peut utiliser des transistors ou alors figer par exemple le fonctionnement de certains de ces moyens.

Ainsi, dans la phase d'étalonnage, le commutateur SW1 relie la sortie de l'additionneur ADD3 à l'entrée du filtre de boucle LPF1, le commutateur SW3 relie la sortie du compteur CNT2 à l'entrée du bloc BTR et l'interrupteur SW2 est ouvert.

Par contre, dans la phase d'émission, l'interrupteur SW1 relie la sortie du filtre de boucle LPF2 à l'entrée du filtre de boucle LPF1, l'interrupteur SW3 relie la sortie du compteur CNT2 à une entrée de l'additionneur ADD2 par l'intermédiaire de moyens MMF de mesure de fréquence et l'interrupteur SW2 est fermé, reliant la sortie du registre RG à l'autre entrée de l'additionneur ADD2 dont la sortie est reliée à l'entrée du filtre de boucle LPF2.

Les moyens MMF délivrent la valeur courante du rapport de fréquences FRP/FRF par différences successives du résultat de comptage fourni par le compteur CNT2. Cela étant en variante on aurait pu aussi utiliser le bloc BTR qui fournit aussi cette valeur courante du rapport de fréquences FRP/FRF.

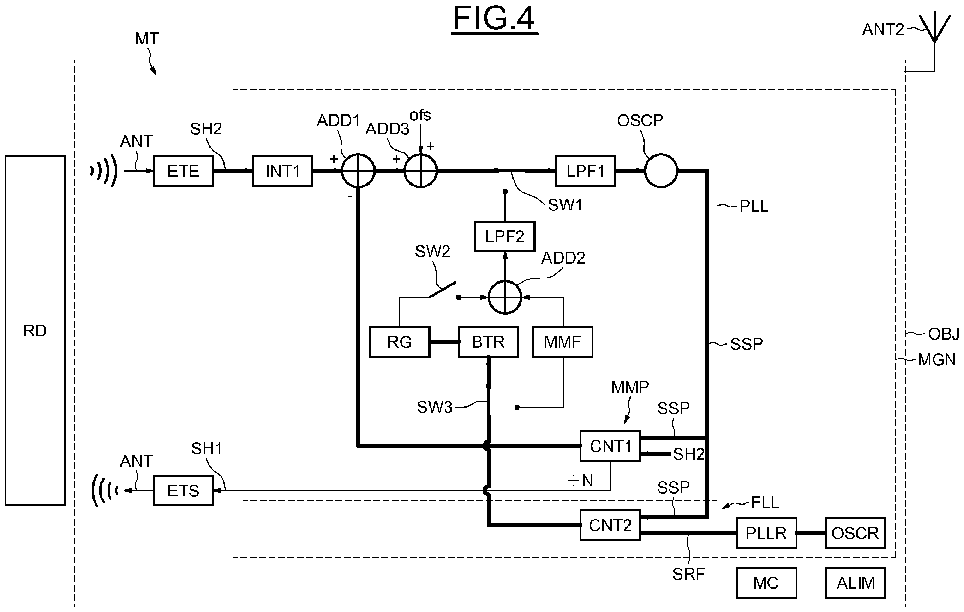

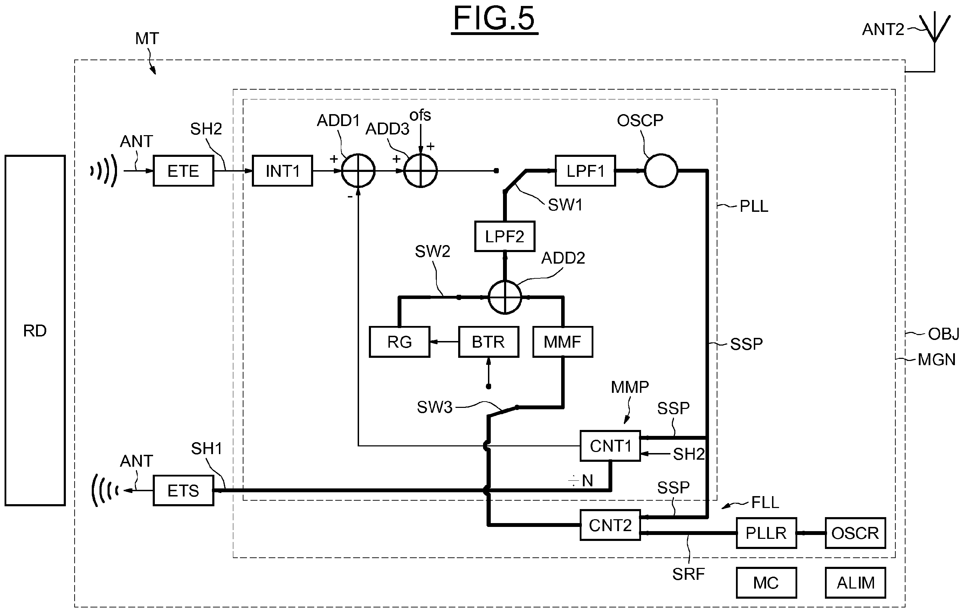

Ceci est illustré plus particulièrement sur les figures 4 et 5.

Sur la figure 4, on est dans la situation d'une phase d'étalonnage dans laquelle l'objet reçoit via l'antenne ANT2 le signal d'horloge secondaire SH2 émis par le lecteur. La boucle à verrouillage de phase PLL permet un asservissement du signal de sortie SSP de l'oscillateur OSCP sur la phase et la fréquence du signal SH2.

Par ailleurs, parallèlement, l'estimation du rapport de fréquences entre la fréquence FRP du signal SSP et la fréquence de référence FRF du signal de référence SRF est effectuée, dans l'exemple décrit ici par l'intermédiaire de mesures glissantes au sein du bloc de traitement BTR.

Le rapport de fréquences, en l'espèce 48,2133, est stocké dans le registre RG.

Puis, comme illustré sur la figure 5, dans la phase d'émission, l'objet émet via l'antenne le signal d'horloge SH1, qui comme on le verra ci-après, est modulé, soit en amplitude soit en phase.

A cet égard, dans cette phase d'émission, la boucle à verrouillage de phase FLL est activée et permet un asservissement uniquement en fréquence du signal de sortie SSP de l'oscillateur OSCP sur la fréquence de référence du signal SRF corrigée par le rapport de fréquences estimé et stocké dans le registre RG, qui agit comme mot de consigne.

Ainsi, de par cet asservissement uniquement en fréquence, la phase du signal SSP n'est pas modifiée par rapport à celle asservie dans la phase d'étalonnage au moyen de la boucle à verrouillage de phase PLL.

Et, de par la division par 64, la fréquence du signal SH1 est égale à 13,56 MHz et la réponse de l'objet est synchrone avec le signal émis par le lecteur.

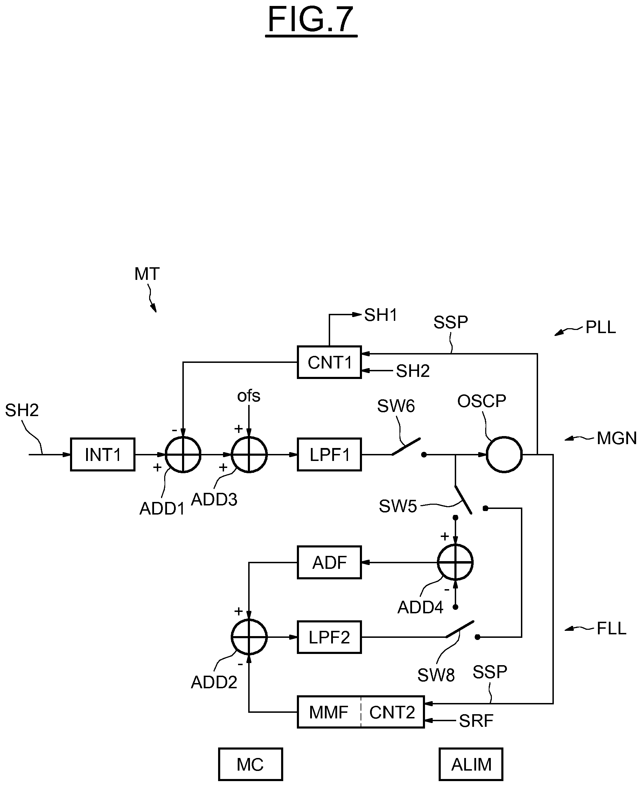

On se réfère maintenant plus particulièrement aux figures 7 à 9 pour illustrer une variante de réalisation et de mise en œuvre de l'invention.

Dans cette variante, comme illustré sur la figure 7, les premiers moyens d'asservissement comportent toujours une boucle à verrouillage de phase PLL comportant l'oscillateur principal OSCP, un filtre de boucle LPF1, et le compteur CNT1.

Par contre, cette fois-ci, les moyens d'estimation comportent une boucle à verrouillage de fréquence FLL possédant une entrée de référence pour recevoir le signal de référence SRF (cette entrée de référence est l'entrée de cadencement de chaque bascule Dff du compteur CNT2).

La boucle à verrouillage de fréquence FLL comporte par ailleurs un deuxième filtre de boucle LPF2 et un filtre adaptatif numérique ADF connecté à la sortie du filtre de boucle LPF1 par l'intermédiaire d'un commutateur SW6 et rebouclé sur le deuxième filtre de boucle LPF2 par l'intermédiaire d'un additionneur ADD2 recevant par ailleurs la sortie des moyens de mesure de fréquences MMF mentionnés ci-avant et disposés à la sortie du compteur CNT2 de façon à délivrer la valeur courante du rapport de fréquences FRP/FRF par différences successives du résultat de comptage fourni par le compteur CNT2.

La sortie du filtre de boucle LPF2 est connectée à l'entrée du filtre adaptatif ADF par l'intermédiaire d'un autre interrupteur SW8 et d'un autre additionneur ADD4.

Par ailleurs, fonctionnellement, l'additionneur ADD4 peut être court-circuité par les commutateurs SW6 et SW5 de façon à pouvoir figer le contenu du filtre adaptatif ADF et relier directement le filtre de boucle LPF2 à l'entrée de l'oscillateur principal OSCP.

La encore les différents commutateurs sont commandés par les moyens de commande MC.

Les deux filtres de boucle LPF1 et LPF2 des boucles à verrouillage de phase PLL et à verrouillage de fréquence FLL sont des filtres de structure classique (typiquement des filtres intégrateurs stabilisateurs) et ont la même fréquence de coupure de telle sorte que les réponses temporelles des deux boucles soient identiques.

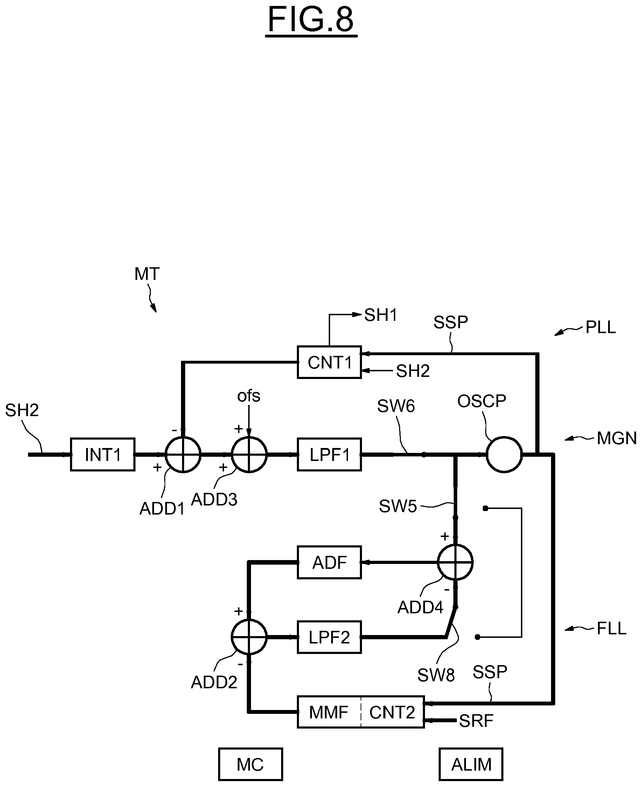

Pendant la phase d'étalonnage, illustrée sur la figure 8, les deux boucles PLL et FLL fonctionnent simultanément mais seule la boucle à verrouillage de phase PLL asservit l'oscillateur OSCP.

De ce fait, le signal SSP de l'oscillateur OSCP est asservi en phase et en fréquence par la boucle à verrouillage de phase PLL sur le signal SH2 et, puisque les deux filtres de boucle LPF1 et LPF2 ont la même fréquence de coupure et que la réponse de la boucle à verrouillage de fréquence est identique à celle de la boucle à verrouillage de phase, le rapport de fréquences FRP/FRF entre la fréquence du signal SSP et la fréquence du signal SRF est déterminé par le filtre adaptatif ADF, la sortie de ce filtre ADF agissant comme un mot de consigne pour la boucle à verrouillage de fréquence.

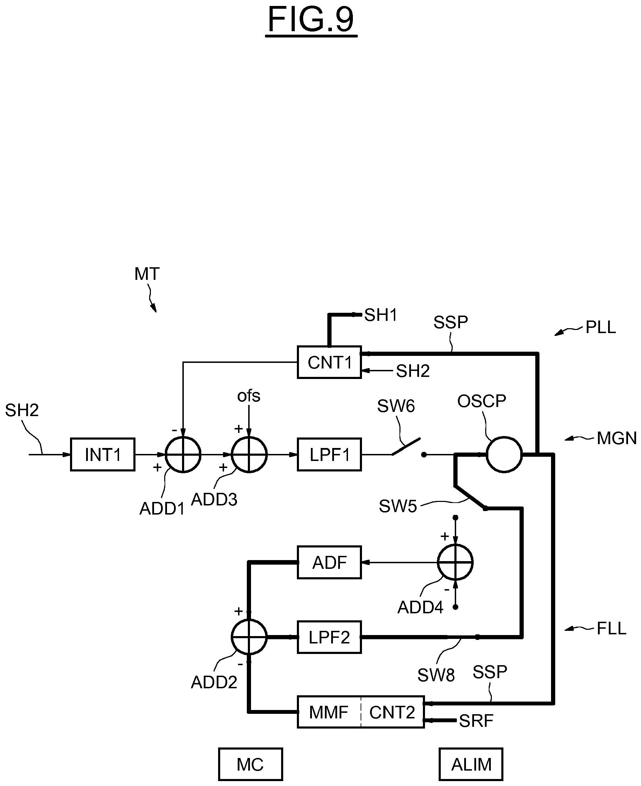

A l'issue de la phase d'étalonnage, dans la phase d'émission (figure 9), les moyens de commande déconnectent l'oscillateur principal OSCP du filtre de boucle LPF1 de façon à désactiver la boucle à verrouillage de phase et la sortie du filtre adaptatif est figée et connectée sur la boucle à verrouillage de fréquence FLL de façon à asservir uniquement en fréquence le signal de sortie de l'oscillateur principal sur la fréquence du signal de référence corrigée par le mot de sortie du filtre adaptatif qui agit là encore comme mot de consigne pour la boucle à verrouillage de fréquence FLL.

Par conséquent, là encore, le signal SH1 reste en phase par rapport au signal SH2.

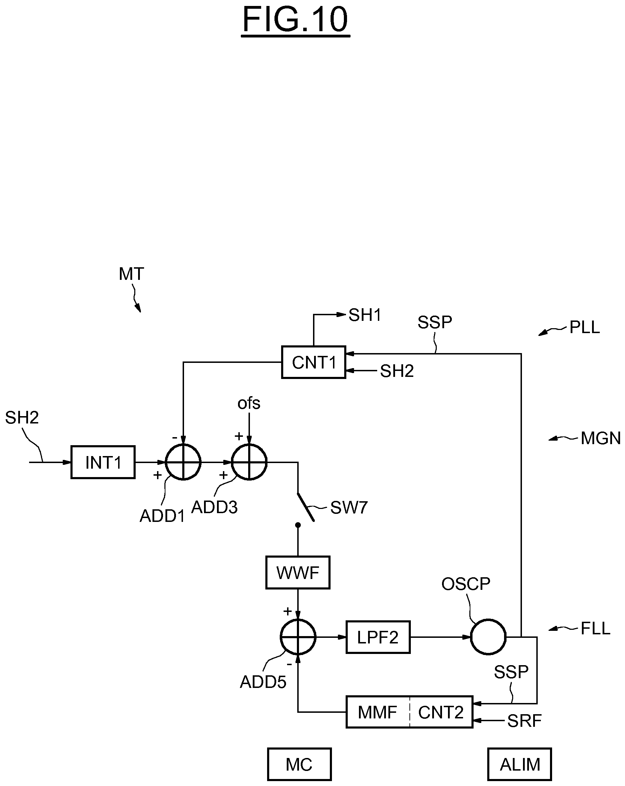

Une autre variante possible de réalisation est illustrée plus particulièrement sur les figures 10 à 12.

Sur la figure 10, on voit que les premiers moyens d'asservissement comportent toujours la boucle à verrouillage de phase PLL qui incluent l'oscillateur principal OSCP, les moyens d'estimation comportent là encore une boucle à verrouillage de fréquence FLL possédant une entrée de référence pour recevoir le signal de référence SRF. Là encore, cette entrée de référence est l'entrée de cadencement de chaque bascule Dff du compteur CNT2, compteur dont la sortie est reliée aux moyens de mesure de fréquence MMF.

La boucle à verrouillage de fréquence comporte un filtre de boucle LPF2 ainsi qu'un filtre intégrateur stabilisateur WWF connecté à l'entrée du filtre de boucle par l'intermédiaire d'un additionneur ADD5 recevant par ailleurs la sortie des moyens de mesure de fréquence MMF incorporant le compteur CNT2.

Le filtre de boucle de la boucle à verrouillage de phase PLL comporte ce filtre intégrateur et stabilisateur WWF ainsi que le filtre de boucle LPF2 de la boucle à verrouillage de fréquence.

Comme illustré sur la figure 10, la sortie de l'additionneur ADD3 peut être déconnectée de l'entrée du filtre intégrateur stabilisateur WWF par l'intermédiaire d'un interrupteur SW7 commandable par les moyens de commande MC.

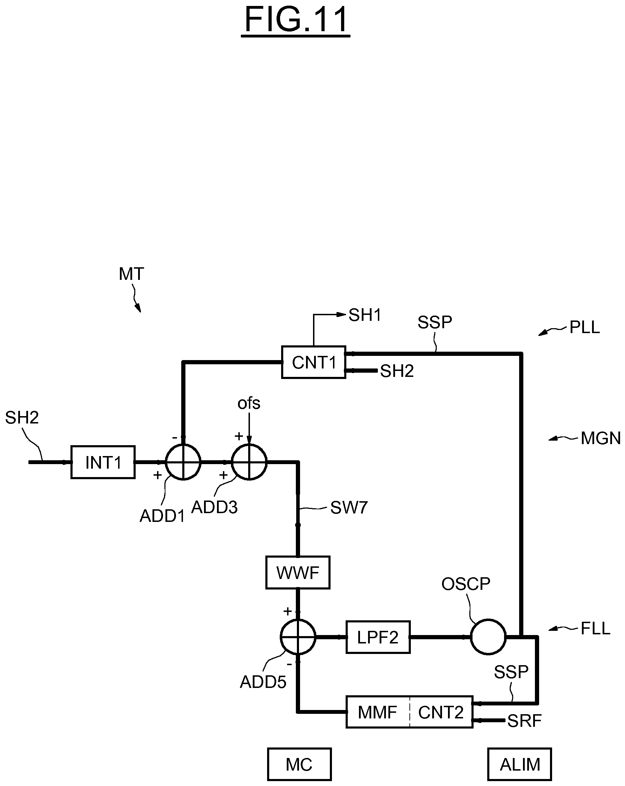

La phase d'étalonnage est illustrée sur la figure 11.

L'asservissement du signal de sortie SSP de l'oscillateur principal OSCP pendant cette phase d'étalonnage est effectué au sein de la boucle à verrouillage de phase PLL et l'estimation du rapport de fréquences est effectuée par le système complet (boucle à verrouillage de phase PLL et boucle à verrouillage de fréquence FLL) à partir du filtre intégrateur stabilisateur WWF dont la sortie forme un mot de consigne pour la boucle à verrouillage de fréquence. Plus précisément la boucle à verrouillage de phase fait converger le système vers le bon rapport de fréquences. La boucle à verrouillage de fréquence équivaut ici à un filtre passe bas et à un intégrateur (conversion de la fréquence à la phase). La boucle à verrouillage de phase ajuste le mot de consigne qui tend vers le rapport de fréquences FRP/FRF.

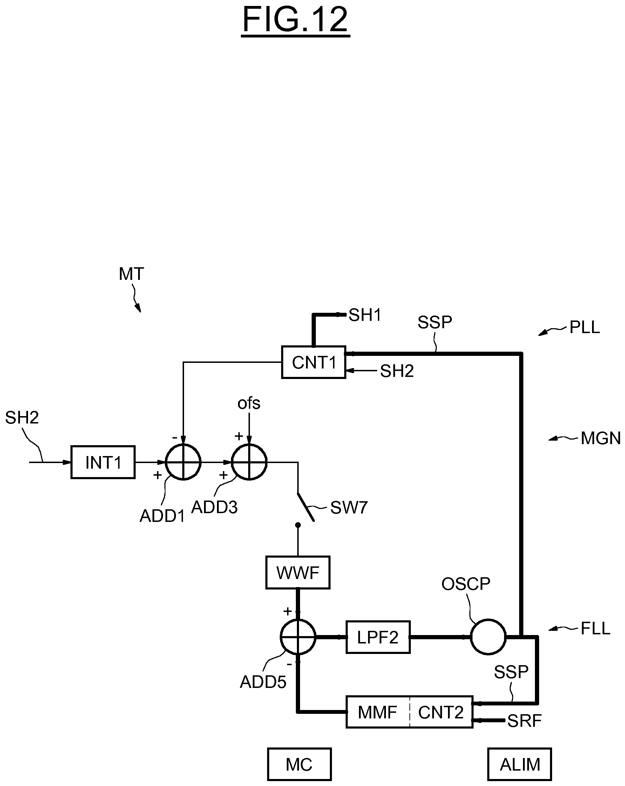

Une fois cette phase d'étalonnage terminée, on passe dans la phase d'émission dans laquelle (figure 12) on ouvre la boucle à verrouillage de phase de façon à la désactiver et on fige la sortie du filtre intégrateur stabilisateur et on maintient sa sortie connectée sur la boucle à verrouillage de fréquence de façon à asservir uniquement en fréquence le signal de sortie SSP de l'oscillateur principal sur la fréquence du signal de référence SRF corrigée par le mot de sortie du filtre intégrateur stabilisateur WWF qui est le rapport de fréquences estimé.

Outre le premier mode de communication qui vient d'être décrit, incluant une phase d'étalonnage et une phase d'émission, particulièrement bien adapté pour des longues périodes d'émission de l'objet vers le lecteur, il est possible de prévoir également un deuxième mode de communication utilisable par exemple en réception de données par l'objet mais aussi plus particulièrement utilisable pour de courtes périodes d'émission de l'objet vers le lecteur.

Ce deuxième mode de communication permet ainsi par exemple d'alterner les fermetures de la boucle à verrouillage de phase en absence d'émission et les ouvertures de cette boucle (roue libre) pendant l'émission du champ par l'objet.

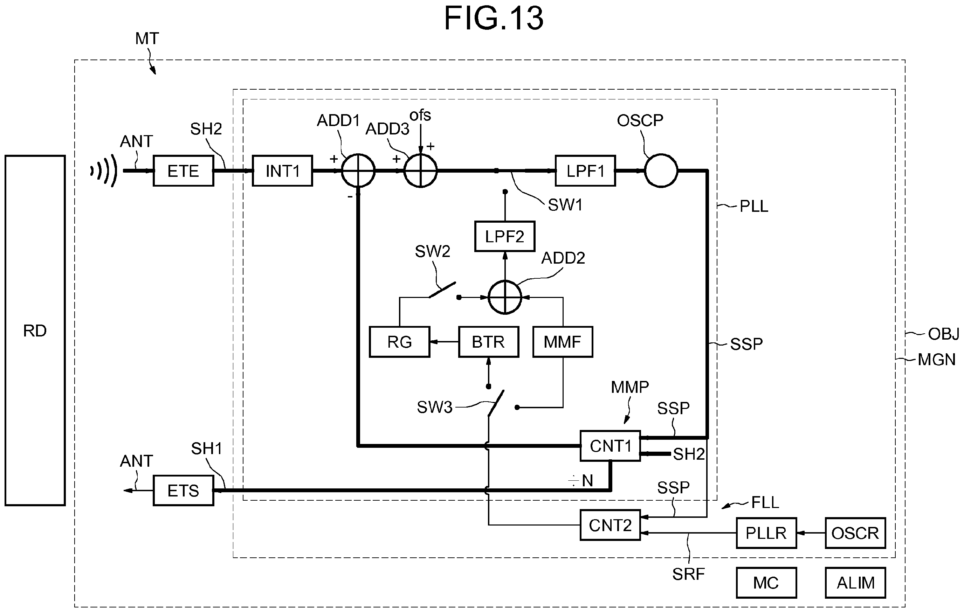

Dans ce cas, comme illustré sur les figures 13, 14 et 15 relatives aux trois modes de réalisation mentionnés ci-avant, on génère le signal d'horloge principal SH1 au sein de l'objet OBJ en effectuant uniquement un asservissement du signal de sortie de l'oscillateur principal commandé OSCP sur la phase et la fréquence du signal d'horloge secondaire SH2 reçu du lecteur.

En pratique, les moyens de traitement MT comportent également des moyens de modulation configurés pour appliquer une modulation sur le signal d'horloge principal généré.

Là, deux possibilités sont offertes.

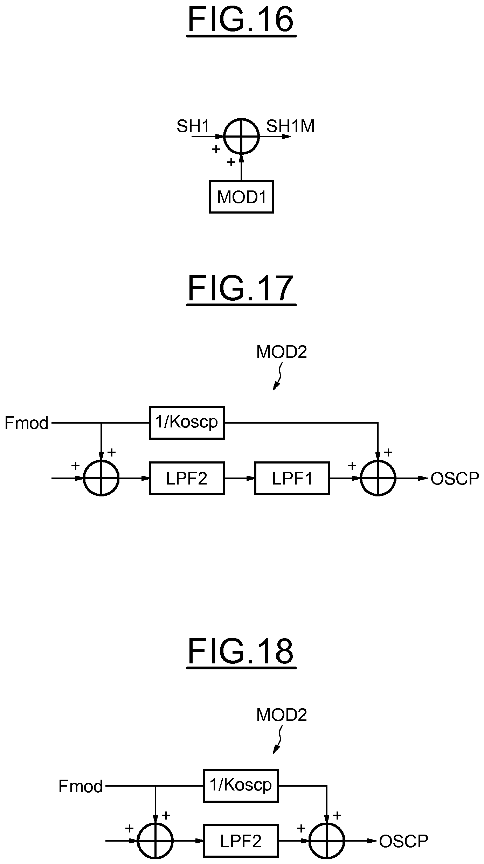

Soit on applique une modulation d'amplitude du type ASK (Amplitude Shift Keying) et dans ce cas, les moyens de modulation MOD1 appliquent une modulation d'amplitude sur le signal d'horloge principal généré SH1 de façon à délivrer un signal d'horloge principal modulé SH1M (figure 16).

Une autre possibilité est d'appliquer une modulation de phase du type modulation par changement de phase (PSK : Phase Shift Keying).

Et, dans ce cas, comme illustré très schématiquement sur les figures 17 à 20, les moyens de modulation de phase MOD2 sont configurés pour appliquer la modulation de phase préalablement à la délivrance du signal d'horloge principal SH1.

En d'autres termes, le signal d'horloge SH1 généré est alors déjà modulé en phase.

Et, dans ce cas, les moyens de modulation sont configurés pour injecter la modulation de phase en deux points de part et d'autre du ou des filtres de boucle de la boucle à verrouillage de phase et/ou de la boucle à verrouillage de fréquence.

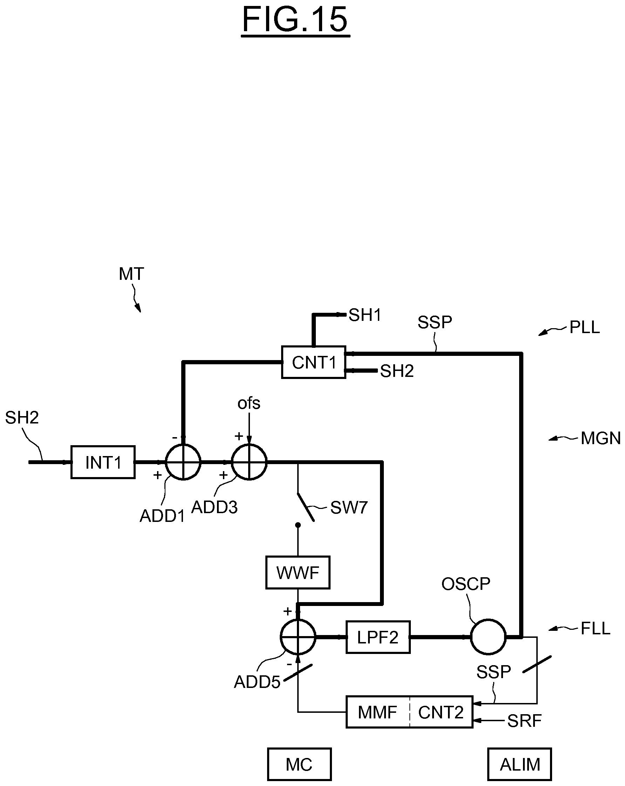

Plus précisément, comme illustré sur les figures 17 à 20, qui montrent respectivement les points d'injection de la modulation sur les schémas de la figure 5, des figures 9 et 11, des figures 13 et 14, et de la figure 15, la modulation de phase PSK est dérivée pour être exprimée en fréquence (Fmod) afin d'être homogène au mot mesuré correspondant au rapport de fréquences FRP/FRF.

La fonction d'intégration de l'oscillateur OSCP permet le retour à la phase et l'ajout de Fmod en entrée de l'oscillateur OSCP est corrigé du gain Koscp de l'oscillateur pour la modulation.

**Revendications**

1. Procédé de communication sans contact d'un objet avec un lecteur par modulation active de charge, comprenant un premier mode de communication comportant une génération d'un signal d'horloge principal (SH1) au sein dudit objet incluant une phase d'étalonnage comportant un asservissement du signal de sortie (SSP) d'un oscillateur principal commandé (OSCP) sur la phase et la fréquence d'un signal d'horloge secondaire (SH2) reçu du lecteur (RD) et une estimation d'un rapport de fréquences entre la fréquence du signal de sortie (SSP) de l'oscillateur principal et une fréquence de référence d'un signal de référence (SRF) issu d'un oscillateur de référence (OSCR) et une phase d'émission comportant un asservissement uniquement en fréquence du signal de sortie (SSP) de l'oscillateur principal sur la fréquence du signal de référence corrigée par ledit rapport estimé, l'asservissement uniquement en fréquence ne modifiant pas la phase du signal de sortie (SSP) de l'oscillateur principal, ledit signal d'horloge principal (SH1) étant issu du signal de sortie (SSP) de l'oscillateur principal.

2. Procédé selon la revendication 1, dans lequel l'estimation dudit rapport de fréquence comprend des mesures glissantes (BTR) entre la fréquence du signal de sortie de l'oscillateur principal et la fréquence de référence.

3. Procédé selon la revendication 1, dans lequel l'asservissement du signal de sortie de l'oscillateur principal pendant la phase d'étalonnage est effectué au sein d'une boucle à verrouillage de phase (PLL) et l'estimation dudit rapport de fréquences est effectuée au sein d'une boucle à verrouillage de fréquence (FLL) à partir d'un filtre adaptatif (ADF) connecté à la sortie du filtre de boucle de la boucle à verrouillage de phase et rebouclé sur le filtre de boucle de la boucle à verrouillage de fréquence, le mot de sortie du filtre adaptatif formant un mot de consigne pour la boucle à verrouillage de fréquence, les deux filtres de boucle ayant une même fréquence de coupure.

4. Procédé selon la revendication 3, dans lequel pendant la phase d'émission on déconnecte de l'oscillateur principal (OSCP) le filtre de boucle (LPF1) de la boucle à verrouillage de phase (PLL), on fige la sortie du filtre adaptatif (ADF) et on asservit uniquement en fréquence le signal de sortie de l'oscillateur principal sur la fréquence du signal de référence corrigée par le mot de sortie du filtre adaptatif (ADF).

5. Procédé selon la revendication 1, dans lequel l'asservissement du signal de sortie (SSP) de l'oscillateur principal pendant la phase d'étalonnage est effectué au sein d'une boucle à verrouillage de phase (PLL) et l'estimation dudit rapport de fréquences est effectuée par un système comportant la boucle à verrouillage de phase (PLL) et une boucle à verrouillage de fréquence (FLL) à partir d'un filtre intégrateur stabilisateur (WWF) dont la sortie forme un mot de consigne pour la boucle à verrouillage de fréquence, le filtre intégrateur stabilisateur (WWF) étant connecté à l'entrée du filtre de boucle (LPF2) de la boucle à verrouillage de fréquence, le filtre de boucle de la boucle à verrouillage de phase (PLL) comportant ledit intégrateur et stabilisateur ainsi que le filtre de boucle de la boucle à verrouillage de fréquence.

6. Procédé selon la revendication 5, dans lequel pendant la phase d'émission on ouvre la boucle à verrouillage de phase (PLL), on fige la sortie du filtre intégrateur stabilisateur (WWF) et on asservit uniquement en fréquence le signal de sortie de l'oscillateur principal sur la fréquence du signal de référence corrigée par le mot de sortie du filtre intégrateur stabilisateur (WWF).

7. Procédé selon l'une des revendications précédentes, comprenant en outre un deuxième mode de communication comportant une génération du signal d'horloge principal (SH1) au sein dudit objet incluant uniquement un asservissement du signal de sortie de l'oscillateur principal (SSP) commandé sur la phase et la fréquence du signal d'horloge secondaire reçu du lecteur.

8. Procédé selon l'une des revendications précédentes, comprenant en outre une génération du signal d'horloge principal (SH1) modulé en phase par une modulation par changement de phase.

9. Objet capable de communiquer sans contact avec un lecteur par modulation active de charge, comprenant des moyens de traitement (MT) comportant des moyens de génération (MGN) configurés pour générer un signal d'horloge principal (SH1) à partir du signal de sortie (SSP) d'un oscillateur principal commandé (OSCP), comportant des premiers moyens d'asservissement configurés pour effectuer un asservissement du signal de sortie (SSP) de l'oscillateur principal sur la phase et la fréquence d'un signal d'horloge secondaire (SH2) reçu du lecteur, des moyens d'estimation configurés pour effectuer une estimation d'un rapport de fréquences entre la fréquence du signal de sortie (SSP) de l'oscillateur principal et une fréquence de référence d'un signal de référence (SRF) issu d'un oscillateur de référence, des deuxièmes moyens d'asservissement configurés pour effectuer un asservissement uniquement en fréquence du signal de sortie (SSP) de l'oscillateur principal sur la fréquence du signal de référence corrigée par ledit rapport estimé, l'asservissement uniquement en fréquence ne modifiant pas la phase du signal de sortie (SSP) de l'oscillateur principal, et des moyens de commande (MCM) configurés pour activer tout d'abord les premiers moyens d'asservissement et les moyens d'estimation puis pour activer les deuxièmes moyens d'asservissement.

**10.** Objet selon la revendication 9, dans lequel les premiers moyens d'asservissement comportent une boucle à verrouillage de phase (PLL) comportant ledit oscillateur principal, les moyens d'estimation comportent des moyens (CNT2, BTR) configurés pour effectuer des mesures glissantes entre la fréquence du signal de sortie de l'oscillateur principal et la fréquence de référence et un moyen de stockage (RG) configuré pour stocker le rapport de fréquences estimé, et les deuxièmes moyens d'asservissement comportent une boucle à verrouillage de fréquence (FLL) comportant ledit oscillateur principal, une entrée de référence pour recevoir le signal de référence et configurée pour recevoir le contenu dudit moyen de stockage en tant que mot de consigne.

**11.** Objet selon la revendication 9, dans lequel les premiers moyens d'asservissement comportent une boucle à verrouillage de phase (PLL) comportant ledit oscillateur principal (OSCP) et un premier filtre de boucle (LPF1), les moyens d'estimation comportent une boucle à verrouillage de fréquence (FLL) possédant une entrée de référence pour recevoir le signal de référence, un deuxième filtre de boucle (LPF2), un filtre adaptatif (ADF) connecté à la sortie du premier filtre de boucle et rebouclé sur le deuxième filtre de boucle, le mot de sortie du filtre adaptatif formant un mot de consigne pour la boucle à verrouillage de fréquence, les deux filtres de boucle ayant une même fréquence de coupure.

**12.** Objet selon la revendication 11, dans lequel les moyens de commande (MCM) sont configurés pour déconnecter l'oscillateur principal du premier filtre de boucle de façon à désactiver la boucle à verrouillage de phase, figer la sortie du filtre adaptatif et connecter la sortie du filtre adaptatif sur la boucle à verrouillage de fréquence de façon à asservir uniquement en fréquence le signal de sortie de l'oscillateur principal sur la fréquence du signal de référence corrigée par le mot de sortie du filtre adaptatif.

**13.** Objet selon la revendication 9, dans lequel les premiers moyens d'asservissement comportent une boucle à verrouillage de phase (PLL) comportant ledit oscillateur principal, les moyens d'estimation comportent une boucle à verrouillage de fréquence (FLL) possédant une entrée de référence pour recevoir le signal de référence, un filtre de boucle, un filtre intégrateur stabilisateur (WWF) connecté à l'entrée du filtre de boucle, la sortie du filtre intégrateur stabilisateur formant un mot de consigne pour la boucle à verrouillage de fréquence, la boucle à verrouillage de phase possédant un filtre de boucle comportant ledit intégrateur et stabilisateur ainsi que le filtre de boucle de la boucle à verrouillage de fréquence.

**14.** Objet selon la revendication 13, dans lequel les moyens de commande (MCM) sont configurés pour ouvrir la boucle à verrouillage de phase de façon à désactiver la boucle à verrouillage de phase, figer la sortie du filtre intégrateur stabilisateur et connecter la sortie du filtre intégrateur et stabilisateur sur la boucle à verrouillage de fréquence de façon à asservir uniquement en fréquence le signal de sortie de l'oscillateur principal sur la fréquence du signal de référence corrigée par le mot de sortie du filtre intégrateur stabilisateur.

**15.** Objet selon l'une des revendications 9 à 14, dans lequel les moyens de commande (MCM) sont en outre configurés pour activer uniquement la boucle à verrouillage de phase de façon à permettre une génération du signal d'horloge principal au sein dudit objet incluant uniquement un asservissement du signal de sortie de l'oscillateur principal commandé sur la phase et la fréquence du signal d'horloge secondaire reçu du lecteur.

**16.** Objet selon l'une des revendications 9 à 15, dans lequel les moyens de traitement (MT) comportent des moyens de modulation (MOD1) d'amplitude configurés pour appliquer une modulation d'amplitude sur le signal d'horloge principal généré.

**17.** Objet selon l'une des revendications 9 à 15, dans lequel les moyens de génération (MGN) comportent des moyens de modulation de phase (MOD2) configurés pour appliquer préalablement à la délivrance du signal d'horloge principal, une modulation de phase du type modulation par changement de phase.

**18.** Objet selon la revendication 17 prise en combinaison avec l'une des revendications 10 à 15, dans lequel les moyens de modulation de phase (MOD2) sont configurés pour injecter la modulation de phase en deux points de part et d'autre du ou des filtres de boucle de la boucle à verrouillage de phase et/ou de la boucle à verrouillage de fréquence.

**19.** Objet selon l'une des revendications 9 à 18, formant un téléphone émulé en mode carte.

EP 3 276 986 B1

**Patentansprüche**

1. Kontaktloses Kommunikationsverfahren zwischen einem Objekt und einem Lesegerät durch aktive Lastmodulation, umfassend einen ersten Kommunikationsmodus, der ein Erzeugen eines Haupttaktsignals (SH1) innerhalb des Objekts beinhaltet, eine Eichphase einschließend, die eine Ansteuerung des Ausgangssignals (SSP) eines gesteuerten Hauptoszillators (OSCP) auf der Phase und der Frequenz eines Sekundärtaktsignals (SH2), das von dem Lesegerät (RD) empfangen wird, und eine Schätzung eines Frequenzverhältnisses zwischen der Frequenz des Ausgangssignals (SSP) des Hauptoszillators und einer Referenzfrequenz eines Referenzsignals (SRF) beinhaltet, das aus einem Referenzoszillator (OSCR) stammt, und eine Emissionsphase, die eine Ansteuerung nur in der Frequenz des Ausgangssignals (SSP) des Hauptoszillators auf der Frequenz des durch das geschätzte Verhältnis korrigierten Referenzsignals beinhaltet, wobei die Ansteuerung nur in der Frequenz die Phase des Ausgangssignals (SSP) des Hauptoszillators nicht modifiziert, wobei das Haupttaktsignal (SH1) aus dem Ausgangssignal (SSP) des Hauptoszillators stammt.

2. Verfahren nach Anspruch 1, wobei die Schätzung des Frequenzverhältnisses gleitende Messungen (BTR) zwischen der Frequenz des Ausgangssignals des Hauptoszillators und der Referenzfrequenz umfasst.

3. Verfahren nach Anspruch 1, wobei die Ansteuerung des Ausgangssignals des Hauptoszillators während der Eichphase innerhalb einer Schleife mit Phasenverriegelung (PLL) durchgeführt wird, und die Schätzung des Frequenzverhältnisses innerhalb einer Schleife mit Frequenzverriegelung (FLL) ausgehend von einem adaptiven Filter (ADF) durchgeführt wird, der mit dem Ausgang des Schleifenfilters der Schleife mit Phasenverriegelung verbunden ist, und mit dem Schleifenfilter der Schleife mit Frequenzverriegelung weiterverschleift ist, wobei das Ausgangswort des adaptiven Filters ein Sollwertwort für die Schleife mit Frequenzverriegelung bildet, wobei die beiden Schleifenfilter eine selbe Grenzfrequenz aufweisen.

4. Verfahren nach Anspruch 3, wobei während der Emissionsphase der Schleifenfilter (LPF1) der Schleife mit Phasenverriegelung (PLL) vom Hauptoszillator (OSCP) getrennt wird, der Ausgang des adaptiven Filters (ADF) eingefroren wird, und das Ausgangssignal des Hauptoszillators nur in der Frequenz auf die Frequenz des durch das Ausgangswort des adaptiven Filters (ADF) korrigierten Referenzsignals angesteuert wird.

5. Verfahren nach Anspruch 1, wobei die Ansteuerung des Ausgangssignals (SSP) des Hauptoszillators während der Eichphase innerhalb einer Schleife mit Phasenverriegelung (PLL) durchgeführt wird, und die Schätzung des Frequenzverhältnisses durch ein System durchgeführt wird, das die Schleife mit Phasenverriegelung (PLL) und eine Schleife mit Frequenzverriegelung (FLL) ausgehend von einem stabilisierenden integrativen Filter (WWF) beinhaltet, dessen Ausgang ein Sollwertwort für die Schleife mit Frequenzverriegelung bildet, wobei der stabilisierende integrative Filter (WWF) mit dem Eingang des Schleifenfilters (LPF2) der Schleife mit Frequenzverriegelung verbunden ist, wobei der Schleifenfilter der Schleife mit Phasenverriegelung (PLL), der den Integrator und Stabilisator, sowie den Schleifenfilter der Schleife mit Frequenzverriegelung beinhaltet.

6. Verfahren nach Anspruch 5, wobei während der Emissionsphase die Schleife mit Phasenverriegelung (PLL) geöffnet wird, der Ausgang des stabilisierenden integrativen Filters (WWF) eingefroren wird, und das Ausgangssignal des Hauptoszillators nur in der Frequenz auf die Frequenz des durch das Ausgangswort des stabilisierenden integrativen Filters (WWF) korrigierten Referenzsignals angesteuert wird.

7. Verfahren nach einem der vorstehenden Ansprüche, weiter einen zweiten Kommunikationsmodus umfassend, der ein Erzeugen des Haupttaktsignals (SH1) innerhalb des Objekts beinhaltet, nur eine Ansteuerung des Ausgangssignals des Hauptoszillators (SSP) einschließend, der auf die Phase und die Frequenz des von dem Lesegerät empfangenen Sekundärtaktsignals gesteuert wird.

8. Verfahren nach einem der vorstehenden Ansprüche, weiter ein Erzeugen des Haupttaktsignals (SH1) umfassend, das durch eine Modulation durch Phasenänderung in der Phase moduliert wird.

9. Objekt, das in der Lage ist, kontaktlos mit einem Lesegerät durch aktive Lastmodulation zu kommunizieren, Bearbeitungsmittel (MT) umfassend, die Erzeugungsmittel (MGN) beinhalten, die konfiguriert sind, um ein Haupttaktsignal (SH1) ausgehend von dem Ausgangssignal (SSP) eines gesteuerten Hauptoszillators (OSCP) zu erzeugen, erste Ansteuerungsmittel beinhaltend, die konfiguriert sind, um eine Ansteuerung des Ausgangssignals (SSP) des Hauptoszillators auf der Phase und der Frequenz eines Sekundärtaktsignals (SH2) durchzuführen, das von dem Lesegerät empfangen wird, Schätzungsmittel, die konfiguriert sind, um eine Schätzung eines Frequenzverhältnisses zwischen der Frequenz des Ausgangssignals (SSP) des Hauptoszillators und einer Referenzfrequenz eines Referenzsignals (SRF) durchzuführen, das aus einem Referenzoszillator stammt, zweite Ansteuerungsmittel, die konfiguriert sind, um eine Ansteuerung nur in der Frequenz des Ausgangssignals (SSP) des Hauptoszillators auf der Frequenz des durch das geschätzte Verhältnis korrigierten Referenzsignals durchzuführen, wobei die Ansteuerung nur in der Frequenz die Phase des Ausgangssignals (SSP) des Hauptoszillators nicht modifiziert, und Steuerungsmittel (MCM), die konfiguriert sind, um zuerst die ersten Ansteuerungsmittel und die Schätzungsmittel zu aktivieren, um danach die zweiten Ansteuerungsmittel zu aktivieren.

10. Objekt nach Anspruch 9, wobei die ersten Ansteuerungsmittel eine Schleife mit Phasenverriegelung (PLL) beinhalten, die den Hauptoszillator beinhalten, die Schätzungsmittel Mittel (CNT2, BTR) beinhalten, die konfiguriert sind, um gleitende Messungen zwischen der Frequenz des Ausgangssignals des Hauptoszillators und der Referenzfrequenz durchzuführen, und ein Speichermittel (RG), das konfiguriert ist, um das geschätzte Frequenzverhältnis zu speichern, und die zweiten Ansteuerungsmittel eine Schleife mit Frequenzverriegelung (FLL) beinhalten, die den Hauptoszillator, einen Referenzeingang zum Empfangen des Referenzsignals beinhaltet, und konfiguriert ist, um den Inhalt des Speichermittels als Sollwertwort zu empfangen.

11. Objekt nach Anspruch 9, wobei die ersten Ansteuerungsmittel eine Schleife mit Phasenverriegelung (PLL) beinhalten, die den Hauptoszillator (OSCP) und einen ersten Schleifenfilter (LPF1) beinhaltet, die Schätzungsmittel eine Schleife mit Frequenzverriegelung (FLL), die einen Referenzeingang zum Empfangen des Referenzsignals besitzt, einen zweiten Schleifenfilter (LPF2), einen adaptiven Filter (ADF), der mit dem Ausgang des ersten Schleifenfilters verbunden ist und mit dem zweiten Schleifenfilter weiterverschleift ist, beinhalten, wobei das Ausgangswort des adaptiven Filters ein Sollwertwort für die Schleife mit Frequenzverriegelung bildet, wobei die beiden Schleifenfilter eine selbe Grenzfrequenz aufweisen.

12. Objekt nach Anspruch 11, wobei die Steuerungsmittel (MCM) konfiguriert sind, um den Hauptoszillator vom ersten Schleifenfilter zu trennen, um die Schleife mit Phasenverriegelung zu deaktivieren, den Ausgang des adaptiven Filters einzufrieren, und den Ausgang des adaptiven Filters auf der Schleife mit Frequenzverriegelung zu verbinden, um das Ausgangssignal des Hauptoszillators nur in der Frequenz auf die Frequenz des durch das Ausgangswort des adaptiven Filters korrigierten Referenzsignals anzusteuern.

13. Objekt nach Anspruch 9, wobei die ersten Ansteuerungsmittel eine Schleife mit Phasenverriegelung (PLL) beinhalten, die den Hauptoszillator beinhaltet, die Schätzungsmittel eine Schleife mit Frequenzverriegelung (FLL) beinhalten, die einen Referenzeingang zum Empfangen des Referenzsignals besitzt, einen Schleifenfilter, einen stabilisierenden integrativen Filter (WWF), der mit dem Eingang des Schleifenfilters verbunden ist, wobei der Ausgang des stabilisierenden integrativen Filters ein Sollwertwort für die Schleife mit Frequenzverriegelung bildet, wobei die Schleife mit Phasenverriegelung einen Schleifenfilter besitzt, der den Integrator und Stabilisator, sowie den Schleifenfilter der Schleife mit Frequenzverriegelung beinhaltet.

14. Objekt nach Anspruch 13, wobei die Steuerungsmittel (MCM) konfiguriert sind, um die Schleife mit Phasenverriegelung zu öffnen, um die Schleife mit Phasenverriegelung zu deaktivieren, den Ausgang des stabilisierenden integrativen Filters einzufrieren, und den Ausgang des stabilisierenden integrativen Filters auf der Schleife mit Frequenzverriegelung zu verbinden, um das Ausgangssignal des Hauptoszillators nur in der Frequenz auf die Frequenz des durch das Ausgangswort des stabilisierenden integrativen Filters korrigierten Referenzsignals anzusteuern.

15. Objekt nach einem der Ansprüche 9 bis 14, wobei die Steuerungsmittel (MCM) weiter konfiguriert sind, um nur die Schleife mit Phasenverriegelung zu aktivieren, um ein Erzeugen des Haupttaktsignals innerhalb des Objekts zu ermöglichen, das nur eine Ansteuerung des Ausgangssignals des gesteuerten Hauptoszillators auf der Phase und der Frequenz des von dem Lesegerät empfangenen Sekundärtaktsignals einschließt.

16. Objekt nach einem der Ansprüche 9 bis 15, wobei die Bearbeitungsmittel (MT) Amplitudenmodulationsmittel (MOD1) beinhalten, die konfiguriert sind, um eine Amplitudenmodulation auf das erzeugte Haupttaktsignal anzuwenden.

17. Objekt nach einem der Ansprüche 9 bis 15, wobei die Erzeugungsmittel (MGN) Phasenmodulationsmittel (MOD2) beinhalten, die konfiguriert sind, um vor der Ausgabe des Haupttaktsignals eine Phasenmodulation vom Typ Modulation durch Phasenänderung anzuwenden.

18. Objekt nach Anspruch 17, in Verbindung mit einem der Ansprüche 10 bis 15, wobei die Phasenmodulationsmittel (MOD2) konfiguriert sind, um die Phasenmodulation in zwei Punkten beiderseits des oder der Schleifenfilter(s) der Schleife mit Phasenverriegelung und/oder der Schleife mit Frequenzverriegelung zu injizieren.

**19.** Objekt nach einem der Ansprüche 9 bis 18, das ein im Kartenmodus emuliertes Telefon bildet.

**Claims**

**1.** A method of contactless communication of an object with a reader by active load modulation, comprising a first communication mode comprising generating a main clock signal (SH1) within said object including a calibration phase comprising locking the output signal (SSP) of a controlled main oscillator (OSCP) onto the phase and frequency of a secondary clock signal (SH2) received from the reader (RD) and estimating a frequency ratio between the frequency of the output signal (SSP) of the main oscillator and a reference frequency of a reference signal (SRF) originating from a reference oscillator (OSCR) and a transmission phase comprising only frequency-locking the output signal (SSP) of the main oscillator onto the frequency of the reference signal corrected by said estimated ratio, the only frequency-locking not modifying the phase of the output signal (SSP) of the main oscillator, said main clock signal (SH1) originating from the output signal (SSP) of the main oscillator.

**2.** The method according to claim 1, wherein estimating said frequency ratio comprises sliding measurements (BTR) between the frequency of the output signal of the main oscillator and the reference frequency.

**3.** The method according to claim 1, wherein locking the output signal of the main oscillator during the calibration phase is carried out within a phase-locked loop (PLL) and estimating said frequency ratio is carried out within a frequency-locked loop (FLL) from an adaptive filter (ADF) connected to the output of the loop filter of the phase-locked loop and looped back to the loop filter of the frequency-locked loop, the output word of the adaptive filter forming a control word for the frequency-locked loop, the two loop filters having the same cut-off frequency.

**4.** The method according to claim 3, wherein during the transmission phase the loop filter (LPF1) of the phase-locked loop (PLL) is disconnected from the main oscillator (OSCP), the output of the adaptive filter (ADF) is frozen and the output signal of the main oscillator is only frequency-locked onto the frequency of the reference signal corrected by the output word of the adaptive filter (ADF).

**5.** The method according to claim 1, wherein locking the output signal (SSP) of the main oscillator during the calibration phase is carried out within a phase-locked loop (PLL) and estimating said frequency ratio is performed by a system comprising the phase-locked loop (PLL) and a frequency-locked loop (FLL) from an integrator stabiliser filter (WWF) whose output forms a control word for the frequency-locked loop, the integrator stabiliser filter (WWF) being connected to the input of the loop filter (LPF2) of the frequency-locked loop, the loop filter of the phase-locked loop (PLL) comprising said integrator and stabiliser as well as the loop filter of the frequency-locked loop.

**6.** The method according to claim 5, wherein during the transmission phase the phase-locked loop (PLL) is opened, the output of the integrator stabiliser filter (WWF) is frozen and the output signal of the main oscillator is only frequency-locked onto the frequency of the reference signal corrected by the output word of the integrator stabiliser filter (WWF).

**7.** The method according to one of the preceding claims, further comprising a second communication mode comprising generating the main clock signal (SH1) within said object including only locking the output signal of the controlled main oscillator (SSP) onto the phase and frequency of the secondary clock signal received from the reader.

**8.** The method according to one of the preceding claims, further comprising generating the main clock signal (SH1) phase-modulated by a phase change modulation.

**9.** An object capable of contactless communication with a reader by active load modulation, comprising processing means (MT) comprising generation means (MGN) configured to generate a main clock signal (SH1) from the output signal (SSP) of a controlled main oscillator (OSCP), comprising first locking means configured to perform a locking of the output signal (SSP) of the main oscillator onto the phase and frequency of a secondary clock signal (SH2) received from the reader, estimation means configured to perform an estimation of a frequency ratio between the frequency of the output signal (SSP) of the main oscillator and a reference frequency of a reference signal (SRF) originating from a reference oscillator, second locking means configured to perform an only frequency-locking of the output signal (SSP) of the main oscillator onto the frequency of the reference signal corrected by said estimated ratio, the only frequency-locking not modifying the phase of the output signal (SSP) of the main oscillator, and control means (MCM) configured to first activate the first locking means and the estimation means then to activate the second locking means.

10. The object according to claim 9, wherein the first locking means comprise a phase-locked loop (PLL) comprising said main oscillator, the estimation means comprise means (CNT2, BTR) configured to carry out sliding measurements between the frequency of the output signal of the main oscillator and the reference frequency and a storage means (RG) configured to store the estimated frequency ratio, and the second locking means comprise a frequency-locked loop (FLL) comprising said main oscillator, a reference input for receiving the reference signal and configured to receive the content of said storage means as a control word.

11. The object according to claim 9, wherein the first locking means comprise a phase-locked loop (PLL) comprising said main oscillator (OSCP) and a first loop filter (LPF1), the estimation means comprise a frequency-locked loop (FLL) having a reference input for receiving the reference signal, a second loop filter (LPF2), an adaptive filter (ADF) connected to the output of the first loop filter and looped back to the second loop filter, the output word of the adaptive filter forming a control word for the frequency-locked loop, the two loop filters having the same cut-off frequency.

12. The object according to claim 11, wherein the control means (MCM) are configured to disconnect the main oscillator from the first loop filter so as to deactivate the phase-locked loop, freeze the output of the adaptive filter and connect the output of the adaptive filter to the frequency-locked loop so as to only frequency-lock the output signal of the main oscillator onto the frequency of the reference signal corrected by the output word of the adaptive filter.

13. The object according to claim 9, wherein the first locking means comprise a phase-locked loop (PLL) comprising said main oscillator, the estimation means comprise a frequency-locked loop (FLL) having a reference input to receive the reference signal, a loop filter, an integrator stabiliser filter (WWF) connected to the input of the loop filter, the output of the integrator stabiliser filter forming a control word for the frequency-locked loop, the phase-locked loop having a loop filter comprising said integrator and stabiliser as well as the loop filter of the frequency-locked loop.

14. The object according to claim 13, wherein the control means (MCM) are configured to open the phase-locked loop so as to deactivate the phase-locked loop, freeze the output of the integrator stabiliser filter and connect the output of the integrator and stabiliser filter to the frequency-locked loop so as to only frequency-lock the output signal of the main oscillator onto the frequency of the reference signal corrected by the output word of the stabiliser integrator filter.

15. The object according to one of claims 9 to 14, wherein the control means (MCM) are further configured to activate only the phase-locked loop so as to allow generation of the main clock signal within said object including only locking the output signal of the controlled main oscillator onto the phase and frequency of the secondary clock signal received from the reader.

16. The object according to one of claims 9 to 15, wherein the processing means (MT) include amplitude modulation means (MOD1) configured to apply an amplitude modulation to the generated main clock signal.

17. The object according to one of claims 9 to 15, wherein the generation means (MGN) comprise phase modulation means (MOD2) configured to apply before delivering the main clock signal, a phase modulation of the phase change modulation type.

18. The object according to claim 17 in combination with one of claims 10 to 15, wherein the phase modulation means (MOD2) are configured to inject the phase modulation in two points on either side of the loop filter (s) of the phase-locked loop and/or the frequency-locked loop.

19. The object according to one of claims 9 to 18, forming a card emulated phone.

FIG.1

## FIG.2

## FIG.3

FIG.4

FIG.5

# FIG.6

EP 3 276 986 B1

# FIG.7

# FIG.8

# FIG.9

EP 3 276 986 B1

# FIG.10

24

# FIG.11

# FIG.12

## FIG.13

EP 3 276 986 B1

# FIG.14

# FIG.15

## FIG.16

## FIG.17

## FIG.18

## FIG.19

## FIG.20

**EP 3 276 986 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2843840 A
- FR 1561153
- US 15139801 B